# EUROPEAN PATENT SPECIFICATION

(11) **EP 4 254 449 B1**
(45) Date of publication and mention of the grant of the patent: **17.09.2025**
(21) Application number: 22305410.7
(22) Date of filing: 31.03.2022
(51) Int. Cl.: H01G 4/012, H10D 1/68, H10D 1/00, H10N 97/00, H01G 4/38, H01G 4/33, H01G 4/005

(54) **AN ELECTRICAL DEVICE COMPRISING A 2D PLANAR CAPACITOR AND A 3D MIM CAPACITOR FORMED IN ANODIC POROUS OXIDE ON A SUBSTRATE**
ELEKTRISCHES BAUELEMENT MIT EINEM 2D-PLANAREN KONDENSATOR UND EINEM 3D-MIM-KONDENSATOR, DIE IN EINEM ANODISCHEN PORÖSEN OXID AUF EINEM SUBSTRAT AUSGEBILDET SIND
UN COMPOSANT ÉLECTRIQUE COMPRENANT UN CONDENSATEUR PLANAIRE 2D ET UN CONDENSATEUR MIM 3D FORMÉS DANS UN OXYDE POREUX ANODIQUE SUR UN SUBSTRAT

(43) Date of publication of application: 04.10.2023
(73) Proprietor: Murata Manufacturing Co., Ltd., Nagaokakyo-shi, Kyoto 617-8555 (JP)
(72) Inventor: JACQUELINE, Sébastien, 14000 CAEN (FR); AUBRY, Yves, 14000 CAEN (FR); VOIRON, Frédéric, 38530 BARRAUX (FR); IOCHEM, Sébastien, 14000 CAEN (FR)
(74) Representative: Cabinet Beau de Loménie

(56) References cited:
- US-A1- 2007 164 434
- US-A1- 2017 194 418
- US-A1- 2021 066 449
- US-A1- 2021 296 283

## Description

### Field of the Invention

The present invention relates to the field of integration and, more particularly, to electrical devices, related semiconductor products, and their methods of manufacture.

### Technical Background

Silicon passive integration technologies are nowadays accessible for industrial design. For example, the PICS technology developed by Murata Integrated Passive Solutions allows integrating high density capacitive components into a silicon substrate. According to this technology, tens or even hundreds of passive components can be efficiently integrated into a silicon die.

In particular, it has been proposed to form three-dimensional (3D) conductive silicon structures by using Reactive Ion Etching, followed by subsequent deposition steps of a dielectric and of a conductive material to form capacitors. The increase in terms of capacitance density results from the capacitors having a 3D shape. These capacitors are known as 3D capacitors. Document WO 2007/125510 discloses a method for forming such 3D capacitors. Further prior art is disclosed in documents US2021/066449A1, US 2017/194418A1, US2007/164434A1 and US2021/296283A1.

In their work titled "Nanotubular metal-insulator-metal capacitor arrays for energy storage" (published in Natural technology, May 2009), P. Banerjee et al. describe a metal-insulator-metal (MIM) structure formed in a porous anodic material, such as porous anodic alumina (PAA) for example. The successive layers of metal, insulator, and then metal follow the contours of the porous material resulting in the MIM structure being embedded inside the pores of the porous material. Banerjee's PAA embedded structure however suffers from high Equivalent Series Resistance (ESR) and limited capacitance density due to the PAA thickness that can be deposited by Atomic Layer Deposition (ALD).

A structure by F. Voiron et al. that improves Banerjee's ESR and capacitance is described in international application publication WO 2015/063420 A1. Voiron's structure results in highly integrated capacitance that may be used in a variety of applications. In this structure the bottoms of the pores are opened and the lower metal layer of the MIM structure contacts a conductive layer that underlies the porous region, providing electrical contact and reducing ESR.

It is desirable to form 2D capacitors alongside 3D capacitors, preferably using the same deposition and photolithography steps for the electrodes and the dielectric layer. For example, the 2D capacitors can be used to obtain capacitors having a capacitance value which is well below what can be manufactured on a 3D structure. This is useful for applications that require these low capacitance values as well as larger capacitance values associated with 3D structures. Another reason for this need is that they facilitate characterizing the deposition of the dielectric layer (typically to check its thickness, its permittivity, its breakdown voltage) without being impacted by how it is deposited on a 3D structure.

The method of document WO 2007/125510 provides a possibility to form a 2D capacitor next to a 3D capacitor without requiring additional manufacturing steps (deposition, photolithography). A 3D capacitor in accordance with this prior art method is usually covered by an insulating layer having multiple openings (called contact openings) that allow accessing, in a single photolithography step, the bottom electrode of a 3D capacitor, the top electrode of a 3D capacitor, the bottom electrode of a 2D capacitor, the top electrode of a 2D capacitor, with the 2D capacitor and the 3D capacitor being manufactured simultaneously.

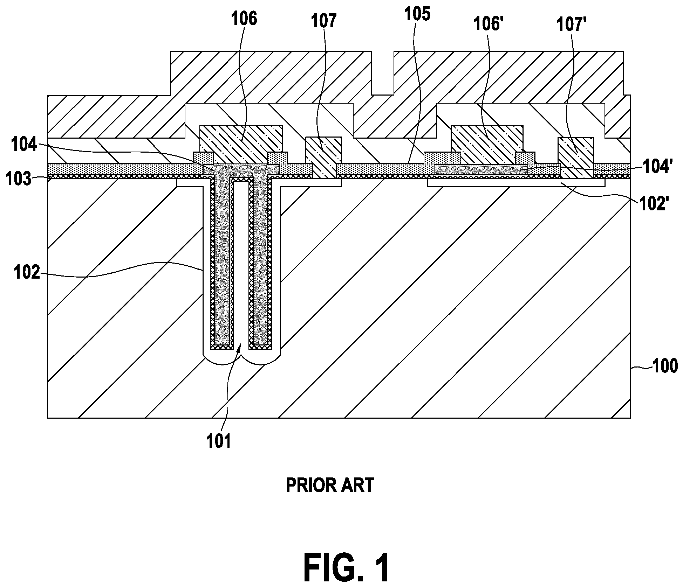

Figure 1 shows an exemplary device comprising a 2D capacitor and a 3D capacitor formed in accordance with the method of document WO 2007/125510. A silicon substrate 100 is provided and 3D structures are formed by Deep Reactive Ion Etching (DRIE). Here, a pillar 101 is formed. The region that includes this pillar 101 is then doped so as to form a conductive silicon region to obtain a bottom capacitor electrode 102, and, separately, a supplementary conductive silicon region to obtain a supplementary bottom capacitor electrode 102'. Subsequently, a dielectric layer 103 is deposited in a conformal manner: this means that the dielectric layer conforms to the contours of the silicon pillar 101 and is deposited with the same thickness on the side walls of the pillar and on the bottom of the trenches that delimit this pillar. The 3D structure is then filled with conductive polysilicon to obtain a top capacitor electrode 104. Conductive polysilicon is also deposited above the supplementary conductive region to obtain a supplementary top capacitor electrode 104'. A 3D capacitor is obtained comprising bottom capacitor electrode 102, dielectric layer 103, and top capacitor electrode 104, a 2D capacitor is also obtained comprising supplementary bottom capacitor electrode 102', dielectric layer 103, and supplementary top capacitor electrode 104'.

As shown on the figure, the bottom capacitor electrode 102 extends further than the top capacitor electrode 104, and this is also the case for the supplementary bottom capacitor electrode 102' which extends further than the supplementary top capacitor electrode 104'. Subsequently, a single insulating layer 105 can be deposited above the structure, and a single photolithography step is carried out to open contacts onto the four capacitor electrodes: the photolithography step includes an etching of the insulating layer 105 and of the dielectric layer 103 to access the bottom electrodes that extend further than the top electrodes in the two capacitors (insulating layer 105 can be referred to as a contact opening layer).

Where insulating layer 105 has been opened (including where the dielectric layer 103 has been opened), conductive metal contacts are formed:
- A top metal contact 106 is formed to electrically contact the top capacitor electrode 104 of the 3D capacitor,
- A bottom metal contact 107 is formed to electrically contact the bottom capacitor electrode 102 of the 3D capacitor,
- A top metal contact 106' is formed to electrically contact the top capacitor electrode 104' of the 2D capacitor,
- A bottom metal contact 107' is formed to electrically contact the bottom capacitor electrode 102' of the 2D capacitor.

Only one deposition and one photolithography are required to obtain the above top and bottom contacts. It appears that for these structures, implementing 2D capacitors alongside 3D capacitors does not require additional steps and only requires the necessary surface area.

Figure 2 shows how, in 3D capacitors formed WO 2015/063420 A1, contact openings are manufactured. Above a silicon substrate 200 having a silicon dioxide layer 201 on top of it (formed by oxidation or alternatively by deposition), a plurality of conductive layers are successively formed: an aluminum layer 202 (by physical vapor deposition), a tungsten layer 203 (by physical vapor deposition), and another thick aluminum layer 204 (by physical vapor deposition).

In order to delimit the portion of the aluminum layer 204 to be anodized, a first hard mask 205 is formed above aluminum layer 204, with an opening. Anodization is then carried out to obtain an anodic porous oxide region 206 comprising straight pores (vertical on the figure) that extend from the top face of the anodic porous region to the tungsten layer 203. In fact, the tungsten layer 203 acts as an anodization barrier.

In a manner which is similar to what has been described in prior art document WO 2019/215284, another hard mask 207 is formed above the structure to delimit the vertical pores that are intended to be used subsequently to form a capacitor. Hard mask 207 therefore comprises an opening that delimits an anodic porous oxide region.

Above the structure and inside the pores, a stack of materials is formed in a conformal manner including:
- A bottom capacitor electrode layer 208 (titanium nitride: TiN),
- A dielectric layer 209 (Oxide-Nitride-Oxide: ONO),
- A top capacitor electrode layer 210 (titanium nitride: TiN)

A 3D capacitor is formed. Subsequently, a conductive layer 211 is formed above the top capacitor electrode layer 210 to facilitate forming a metal contact. A photolithography step is then carried out to delimit this layer. During the etching of this photolithography, the portions of the top capacitor electrode layer 210 not intended to be covered by the conductive layer 211 are etched away as well.

An opening is then formed on the right of the anodic porous oxide region through the dielectric layer 209 and the bottom capacitor electrode layer 208, so as to reach the aluminum layer 204 (through this opening, it is possible to electrically contact the bottom capacitor electrode 208 through the aluminum layer 204). Forming this opening can be performed by means of a photolithography step using a specific mask configured to delimit the opening and an etching through the hard mask 205, the hard mask 207, the bottom capacitor electrode layer 208 and the dielectric layer 209.

Subsequently, an insulator layer 212 is deposited and patterned to delimit two contact openings, one for the top capacitor electrode through conductive layer 211, and one for the bottom capacitor electrode through the opening formed on the right of the figure. More precisely, the bottom electrode is electrically accessed through the aluminum layer 204, and the tungsten layer 203, which contacts the bottom capacitor layer 208 at the bottom of the pores where this layer is deposited.

The above implementation is not suitable to form a 2D capacitor having accessible electrodes and more precisely an accessible bottom electrode that would be formed with the layer of bottom electrode 208. In fact, making such an electrode accessible would require etching through the dielectric layer and stopping at the level of the electrode, which can be particularly difficult to obtain. The layers that form the 3D capacitors are particularly thin, making stopping on the bottom layer difficult.

Thus, there exists a need for a solution to form 2D and 3D capacitors when using anodic porous oxide to accommodate the 3D capacitors.

The present invention has been made in the light of the above problems.

### Summary of the Invention

The present invention provides an electrical device according to claim 1 comprising:
a substrate,
a conductive anodization barrier above the substrate,
a metal region above the conductive anodization barrier,
an anodic porous oxide region above the substrate, comprising straight pores extending from a top face of the anodic porous oxide region to the conductive oxidation barrier (the pores are substantially perpendicular to this top face and the conductive anodization barrier), the anodic porous oxide region being adjacent to the metal region,
an insulating region above the metal region and the anodic porous oxide, having a first opening delimiting a portion of the anodic porous oxide region and a second opening delimiting a portion of the metal region,
a bottom capacitor electrode layer including a 3D (three-dimensional) portion extending inside the pores of the portion anodic porous oxide region (for example, the 3D portion is conformal and conforms to the shape of the pores - for example the 3D portion is in electrical contact with the conductive anodization barrier - for example, by 3D, what is meant is that the 3D portion comprises surfaces extending in the three orthogonal dimensions) and a 2D portion extending above the insulating region, the 2D portion and the 3D portion of the bottom capacitor electrode layer being in electrical contact (i.e. they form, together, a contiguous layer, for example the same layer deposited in a single deposition step),
a dielectric layer (for example a single layer, deposited conformally) including a 2D (two-dimensional) portion above the 2D portion of the first capacitor electrode layer, and a 3D portion above the 3D portion of the bottom capacitor electrode layer and inside the pores of the portion of the anodic porous oxide region (for example, by 2D, what is meant is that the 2D portion comprises surfaces that only extend in two dimensions (a plane)),
a top capacitor electrode layer (for example a single layer, deposited conformally) including a 2D portion above the 2D portion of the dielectric layer, and a 3D portion above the 3D portion of the dielectric layer and inside the pores of the portion,
a 2D top metal contact (i.e. a conductive layer that allows electrically contacting a capacitor electrode, for example a conductive layer electrically connected to a capacitor electrode, the capacitor electrode being the portion that participates to the capacitance of the capacitor) above and in electrical contact with the 2D portion of the top capacitor electrode layer,
a 3D top metal contact (i.e. a conductive layer) above and in electrical contact with the 3D portion of the top capacitor electrode layer, and
a 2D bottom metal contact (i.e. a conductive layer) in the second opening (the second opening is filled with the metal contact), above and in electrical contact with the 2D portion of the bottom capacitor electrode layer through the portion of the metal region and the 3D portion of the bottom capacitor electrode layer.

Thus, the above device proposes to implement a 2D capacitor formed by the 2D portions of: the bottom capacitor electrode layer, the dielectric layer, and the top capacitor electrode layer. The above device also implements a 3D capacitor formed by the 3D portions of: the bottom capacitor electrode layer, the dielectric layer, and the top capacitor electrode layer. The bottom electrode of the 2D capacitor is accessible through the bottom electrode of the 3D capacitor and the metal contact that, in the prior art, was used as a metal contact to contact the bottom electrode of a 3D capacitor. In fact, this metal contact is used to contact the bottom electrode of both the 2D and the 3D capacitor.

The inventors of the present invention have observed that as the 2D capacitor can be used for characterizing the deposition of the materials deposited in the porous region, there is no need to have a dedicated metal contact for the 2D bottom capacitor electrode, and that it is possible to share it with the 3D capacitor.

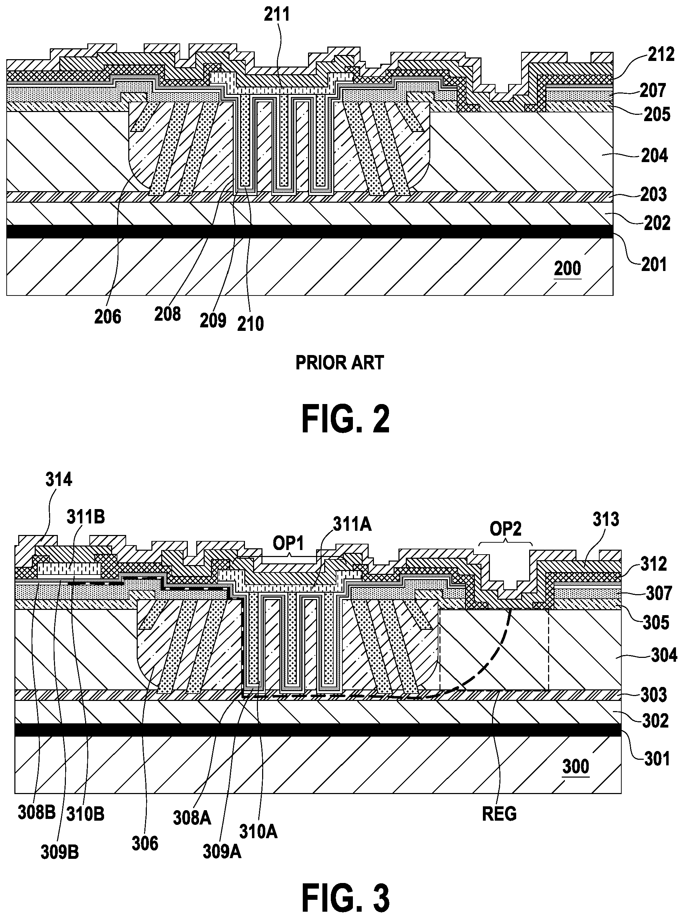

Also, delimiting the 2D portion and the 3D portion of the top capacitor electrode layer can be performed in the photolithography step used to delimit the conductive layer (for example conductive layer 211 in figure 2) in the devices of the prior art.

Hence, manufacturing the above device does not increase the number of manufacturing steps required.

In the above device, the 2D bottom metal contact is on a side of the anodic porous oxide region opposite to the 2D top metal contact.

According to a particular embodiment, the device comprises a passivation layer having:
a first opening delimiting the 2D top metal contact by exposing the 2D top metal contact,
a second opening delimiting the 3D top metal contact by exposing the 3D top metal contact,
a third opening delimiting the 2D bottom metal contact by exposing the 2D bottom metal contact (and also, as they are shared, a 3D bottom metal contact in electrical contact with the 3D portion of the bottom capacitor electrode layer).

According to a particular embodiment, the metal region including the portion of the metal region in electrical contact with the 2D bottom metal contact partially surrounds the 3D portion of the top capacitor electrode layer and the 2D portion of the top capacitor electrode.

This arrangement facilitates conceiving an arrangement for the 3D portion of the top capacitor electrode and the 2D portion of the top capacitor electrode for which the current path between the 2D portion of the bottom capacitor electrode layer and the corresponding metal contact.

By partially surrounding, what is meant is that this metal region can form a contour, a ring, a wall surrounding, with one or more openings (where there is no 2D bottom metal contact). For example, in the present application, a surrounding can be observed from the top of the device, a surrounding can be a 2 dimensional surrounding, in the plane of the devices (for example in a plane parallel to the top face of the anodic porous oxide region).

According to a particular embodiment, the metal region including the portion of the metal region in electrical contact with the 2D bottom metal contact completely surrounds the 3D portion of the top capacitor electrode layer and the 2D portion of the top capacitor electrode.

In this particular embodiment, this metal region forms a ring and this decreases even more the ESR.

According to a particular embodiment, the second opening delimiting a portion of the metal region partially surrounds the 3D portion of the top capacitor electrode layer and the 2D portion of the top capacitor electrode layer.

In this particular embodiment, the second opening, which opens onto the metal region, forms a contour, a ring, a wall surrounding, with one or more openings. This allows forming a 2D bottom metal contact (which fills the second opening) that will also surround the 3D portion. This also adds multiple parallel current paths and decreases the ESR. In this particular embodiment, the metal region also surrounds the 3D portion as the second opening opens onto this metal region.

According to a particular embodiment, the second opening delimiting a portion of the metal region completely surrounds the 3D portion of the top capacitor electrode layer and the 2D portion of the top capacitor electrode layer.

In this particular embodiment, this second opening forms a ring and this decreases even more the ESR.

According to a particular embodiment, the 2D portion of the top capacitor electrode layer is surrounded (partially or completely) by the 3D portion of the top capacitor electrode layer.

In this particular embodiment, the 2D portion of the top capacitor electrode layer and also the 2D portion of the bottom capacitor electrode layer are surrounded by the 3D portion of the top capacitor electrode layer and also the 3D portion of the bottom capacitor electrode layer. This decreases the equivalent series resistor (ESR) of the 2D capacitor as multiple parallel current paths are provided between the 2D bottom electrode and the 3D bottom electrode.

In fact, it has been observed that the 2D portion of the bottom electrode layer and the connection between this electrode and the 3D portion of the bottom electrode layer may be slightly resistive. The bottom electrode layer can be thin, and have a sheet resistivity of 10 to 1000 ohms per square. On the contrary, the metal region has a low resistivity, and the 3D bottom electrodes only spread through the thickness of the metal over a relatively large surface (hence, this portion does not contribute significantly to the ESR). It is therefore preferable to provide multiple parallel current paths, between the 2D portion of the bottom electrode layer and the 3D portion of the bottom electrode layer so as to limit the distance that the current has to go through between two electrodes. The arrangement in which the 3D portion surrounds the 2D portion is one such arrangement that provides this effect, in particular as the two portions are of a same layer. The advantageous effect is obtained because the 3D portion is present in all the directions around the 2D portion.

It should be noted that this embodiment is advantageously compatible with the embodiment in which, the metal region including the portion of the metal region in electrical contact with the 2D bottom metal contact partially surrounds the 3D portion of the top capacitor electrode layer and the 2D portion of the top capacitor electrode.

According to a particular embodiment, the device comprises multiple 2D portions of the top capacitor electrode layer forming islands surrounded (partially or completely) by the 3D portion of the top capacitor electrode layer.

In this embodiment, the 2D capacitor is divided into multiple portions (islands) surrounded by 3D capacitors/anodic porous oxide. This provides a distribution of parallel current paths from the 2D bottom capacitor electrode to the 3D bottom capacitor electrode, and consequently reduces the ESR of the 2D capacitor.

Also, this device allows forming an arrangement which maximizes the 2D capacitance value. Also, this increases the interface surface between the 2D bottom capacitor electrode and the 3D bottom capacitor electrode.

In this embodiment, all the 2D portions of the top capacitor electrode layer can be connected together through an additional metal contact.

According to a particular embodiment, the 3D portion of the top capacitor electrode layer is surrounded by the 2D portion of the top capacitor electrode layer.

In this embodiment, it is the 3D portion which is surrounded by the 2D portion of the top capacitor layer. In this configuration, it should be noted that the second opening may be for example surrounded by the 3D portion/the anodic porous oxide region. This reduces the ESR.

According to a particular embodiment multiple 3D portions of the top capacitor electrode layer forming islands surrounded by the 2D portion of the top capacitor electrode layer.

In this embodiment, the 3D capacitor/the anodic porous oxide is divided into multiple portions (islands) surrounded by the 2D portions of the top capacitor layer (i.e. the 2D capacitor). This provides a distribution of parallel current paths from the 2D bottom capacitor electrode to the 3D bottom capacitor electrode, and consequently reduces the ESR of the 2D capacitor.

According to a particular embodiment, the 2D portion of the top capacitor electrode layer and the 3D portion of the top capacitor electrode layer are arranged so that a unitary pattern of the 2D portion of the top capacitor electrode layer and the 3D portion of the top capacitor electrode layer is repeated in a paving of the unitary pattern.

It has been observed that repeating a pattern provides a distribution of parallel current paths and reduces the ESR.

According to a particular embodiment, the device presents a first plane of symmetry when observed from the top.

This has also been observed to provide a reduced ESR.

According to a particular embodiment, the device presents a second plane of symmetry orthogonal with the first plane of symmetry when observed from the top.

The invention also provides a method of manufacturing an electrical device according to claim 14 comprising:
providing a substrate,
forming a conductive anodization barrier above the substrate,
depositing a metal layer above the substrate,
anodizing a region of the metal layer to obtain:
   an anodic porous oxide region above the substrate, comprising straight pores extending from a top face of the anodic porous oxide region to the conductive anodization barrier,
   a metal region above the substrate, the anodic porous oxide region being adjacent to the metal region,
forming an insulating region (it should be noted that this step can be performed prior to anodizing a region of the metal layer, to delimit this region) above the metal region and the anodic porous oxide, having a first opening delimiting a portion of the anodic porous oxide region and a second opening delimiting a portion of the metal region,
forming a bottom capacitor electrode layer including a 3D portion extending inside the pores of the portion anodic porous oxide region and a 2D portion extending above the insulating region, the 2D portion and the 3D portion of the bottom capacitor electrode layer being in electrical contact,
forming a dielectric layer including a 2D portion above the 2D portion of the first capacitor electrode layer, and a 3D portion above the 3D portion of the bottom capacitor electrode layer and inside the pores of the portion of the anodic porous oxide region,
forming a top capacitor electrode layer including a 2D portion above the 2D portion of the dielectric layer, and a 3D portion above the 3D portion of the dielectric layer and inside the pores of the portion,
forming a 2D top metal contact above and in electrical contact with the 2D portion of the top capacitor electrode layer,
forming a 3D top metal contact above and in electrical contact with the 3D portion of the top capacitor electrode layer, and
forming a 2D bottom metal contact in the second opening, above and in electrical contact with the 2D portion of the bottom capacitor electrode layer through the portion of the metal region and the 3D portion of the bottom capacitor electrode layer.

This method can be adapted to manufacture any one of the above defined embodiments of the electrical device according to the appended claims.

The invention also provides a method for characterizing an electrical device according to claim 15, comprising measuring a capacitance value or a breakdown voltage or a leakage current (or insulation resistance) or an equivalent series resistance of a capacitor formed between the 2D top metal contact and the 2D bottom metal contact on an electrical device as defined above in any one of its embodiments and the appended claims.

### Brief Description of the Drawings

Further features and advantages of the present invention will become apparent from the following description of certain embodiments thereof, given by way of illustration only, not limitation, with reference to the accompanying drawings in which:
- Figure 1, already described, shows a device according to the prior art,
- Figure 2, already described, shows a device according to the prior art,
- Figure 3 is a side view of a device according to an example,
- Figure 4 is a top view of a device according to an example,
- Figure 5 is a top view of a device according to an example, and
- Figure 6 is a top view of a device according to an example.

### Detailed Description of Example Embodiments

We will now describe an electrical device including a 2D (two dimensional) and a 3D (three dimensional) capacitor manufactured simultaneously.

Figure 3 is a cross section of an electrical device according to an example.

Here, a silicon substrate 300 is used to support the structure. Other materials may be used. A silicon dioxide layer 301 has been grown on the top face of silicon substrate 300 by oxidation.

Subsequently, a first aluminum layer 302 is formed (here by physical vapor deposition), and, on top of it, a tungsten layer 303 (by physical vapor deposition). The tungsten layer will act as a conductive anodization barrier above the substrate, for a subsequent anodization step.

A thick aluminum layer 304 is formed (by physical vapor deposition) on the tungsten layer. This thick aluminum layer may have a thickness of a few micrometers, typically 7 micrometers.

In order to delimit the portion of the aluminum layer 304 to be anodized, a first hard mask 305 (insulating) is formed above aluminum layer 304, with an opening. Anodization is then carried out to obtain an anodic porous oxide region 306 comprising straight pores (vertical on the figure) that extend from the top face of the anodic porous region to the tungsten layer 303 (as the tungsten layer acts as an anodization barrier).

It should be noted that the invention can be implemented with any metal selected such that, when it is anodized, straight pores that extend orthogonally to the surface exposed to the electrolyte are produced.

Subsequently, and in a manner which is known in itself from prior art document WO 2019/215284, another hard mask 307 is formed above the structure to delimit the vertical pores that are intended to be used subsequently to form a 3D capacitor. Hard mask 307, which is insulating (for example comprising silicon dioxide) therefore comprises a first opening OP1 that delimits an anodic porous oxide region.

Above the structure and inside the pores, a stack of materials is formed in a conformal manner comprising, from bottom to top:
- A bottom capacitor electrode layer (titanium nitride: TiN) comprising a 3D portion 308A inside the pores and a 2D portion 308B above the second hard mask, with the two portions electrically connected together as they form single layer,
- A dielectric layer (for example a Oxide-Nitride-Oxide layer (ONO), or aluminum oxide, or hafnium oxide) comprising a 3D portion 309A inside the pores and a 2D portion 309B, respectively above the 3D portion of the bottom capacitor electrode layer and the 2D portion of the the bottom capacitor electrode layer,
- A top capacitor electrode layer (titanium nitride: TiN) comprising a 3D portion 310A inside the pores and a 2D portion 310B, respectively above the 3D portion of the dielectric layer and the 2D portion of the dielectric layer.

These three layers are deposited in a conformal manner, they conform to the shape of the pores, and, where the surface is flat (above the second hard mask for example), they conform to this flatness.

A 3D capacitor is formed, comprising the 3D portion 308A of the bottom capacitor electrode layer, the 3D portion 309A of the dielectric layer, and the 3D portion 310A of the top capacitor electrode layer. It should be noted that in a 3D capacitor, the surfaces of the functional electrodes (the surfaces that face each other that contribute to the capacitance) extend in three dimensions (horizontally at the bottom of the pores and vertically on the walls of the pores on the figure).

A 2D capacitor has also been formed, comprising the 2D portion 308B of the bottom capacitor electrode layer, the 2D portion 309B of the dielectric layer, and the 2D portion 310B of the top capacitor electrode layer. It should be noted that in a 2D capacitor, the surfaces of the functional electrodes (the surfaces that face each other that contribute to the capacitance) extend in two dimensions (horizontally on the figure).

A conductive layer, including aluminum, is then deposited above the structure. Through a photolithography step, two metal contacts are formed:
3D top metal contact 311A above and in electrical contact with the 3D portion 310A of the top capacitor electrode,
2D top metal contact 311B above and in electrical contact with the 2D portion 310B of the top capacitor electrode.

It should be noted that the photolithography step will include an etching of the portions of the top capacitor electrode layer not covered by metal contact 311A or metal contact 311B, and the two top capacitor electrodes are at this stage separated.

A second opening OP2 is formed on a side of the anodic porous oxide region opposite to the side including the 2D capacitor, through the two hard masks 305 and 307, and the portions of the dielectric layer and of the bottom capacitor layer. In fact, this opening opens onto a region REG of the metal layer 304.

It should be noted that in all the embodiments of the present disclosure, the second opening is formed on a side of an anodic porous oxide region opposite to the side including a 2D capacitor (or a portion of 2D capacitor, or even a 2D portion of top capacitor electrode).

A metal contact 313 is then formed and patterned in this second opening, with a passivation layer 314 covering it. The material used for the metal contact is also deposited on metal contacts 311A and 311B.

It appears that an electrical contact is formed between metal contact 313 and the 2D portion of the bottom capacitor electrode layer, through the metal region REG, the tungsten layer 303, and the 3D portion of the bottom capacitor electrode layer. This electrical contact is represented by means of a thick dashed line. Consequently, metal contact 313 is a 2D bottom metal contact as well as a 3D bottom metal contact.

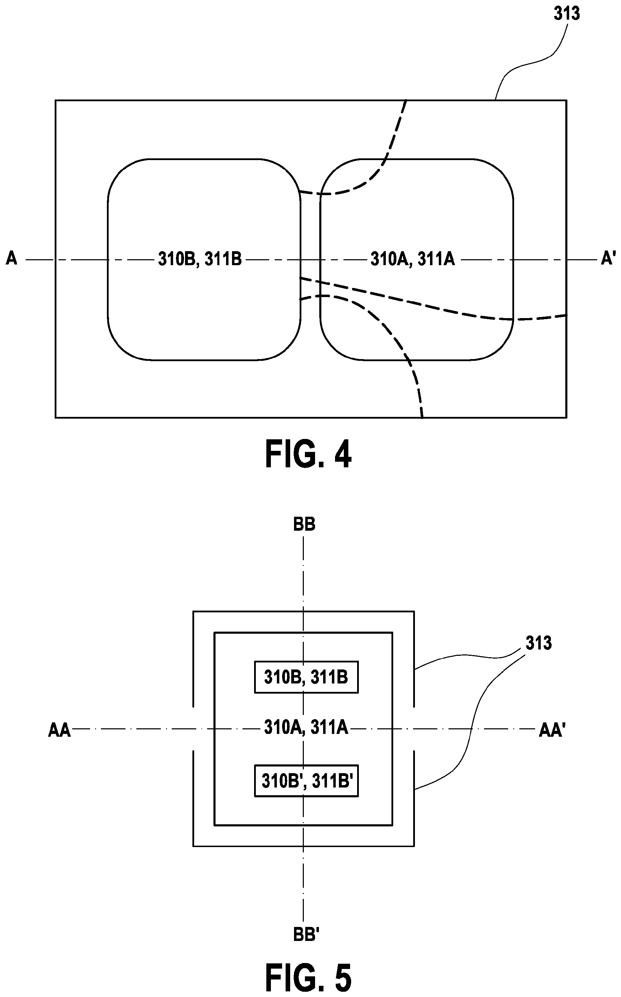

Figure 4 is a top view of a device according to an example. The references of figure 3 are used on this figure to designate the same elements. As can be observed on the figure, various current paths will be available for the 2D capacitor at the interface between the 2d capacitor and the 3D capacitor, and then around the 3D capacitor to reach the 2D bottom metal contact 313 (and, underneath it, the metal region REG). This embodiment facilitates arranging the components within this surrounded region.

In fact, the anodic porous oxide region is completely surrounded in this embodiment.

Furthermore, the device of the present figure presents a plane of symmetry A-A': this participates to reducing the ESR as it favors structures with more equivalent parallel current paths.

It should be noted that this structure allows characterizing the device, for example by measuring the capacitance of the 2D capacitor. Also, the capacitance density gain is provided by measuring the 3D capacitance and computing the ratio of capacitance values. Other parameters such as the breakdown voltage and leakage currents can be measured.

Figure 5 is a top view of a device according to another example. The references of figure 3 are also used on this figure to designate the same elements for the sake of simplicity, even though the shapes of the elements differ from figure 4.

On this figure, the 2D bottom metal contact partially surrounds both the 3D top metal contact and the 2D top metal contact. In fact, there are two openings on the ring formed by the 2D bottom metal contact. These two openings allow forming a track that facilitates the use of electrical probes as they allow forming tracks that bring the electrical signal outside of the region surrounded by the 2D bottom metal contact (and the tracks associates with the 2D bottom metal contact). These two openings are optional.

The 2D top metal contact 311B, 311B' and the 2D portion of the top capacitor electrode layer 310B, 310B' are divided into 2 islands that are surrounded by the 3D top metal contact 311A and the 3D top capacitor electrode layer 310A (and, also, the anodic porous oxide region).

Also, the device presents two planes of symmetry that are orthogonal with each other: plane AA-AA' horizontal on the figure, and plane BB-BB' vertical on the figure.

The arrangement of figure 5 has been observed to provide an ESR of about 7 ohms for a 2D capacitor having a capacitance of about 0.3nF, and this ESR results from the two islands of 2D capacitors, and the plane of symmetries that provide a plurality of equivalent parallel current paths. In fact, there are many possibilities for the current to reach the 3D portion through a shortened 2D path and thus reducing its resistive contribution.

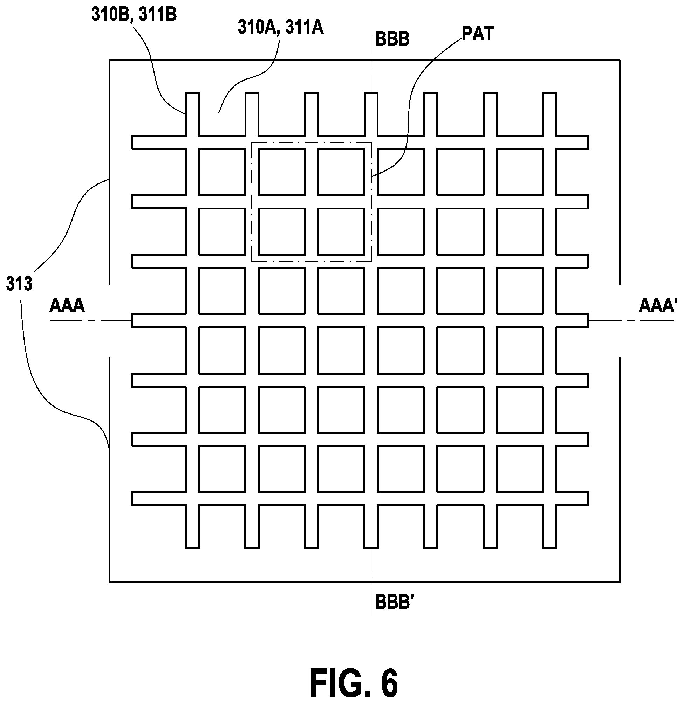

Figure 6 is a top view of a device according to another example. The references of figure 3 are also used on this figure to designate the same elements for the sake of simplicity, even though the shapes of the elements differ from figure 4 and 5.

On this figure, the 2D bottom metal contact partially surrounds both the 3D top metal contact and the 2D top metal contact. In fact, there are two openings on the ring formed by the 2D bottom metal contact.

The 2D top metal contact 311B and the 2D portion of the top capacitor electrode layer 310B has a grid shape, surrounded by the 3D top metal contact 311A and the 3D top capacitor electrode layer 310A (and, also, the anodic porous oxide region). In fact, the 2D portion of the top capacitor electrode layer and the 3D portion of the top capacitor electrode layer are arranged so that a unitary pattern PAT of the 2D portion of the top capacitor electrode layer and the 3D portion of the top capacitor electrode layer is repeated in a paving of the unitary pattern.

It can be understood that repeating this unitary pattern PAT will provide more parallel equivalent current paths that participate to reducing the ESR of the 2D capacitor.

Also, the device presents two planes of symmetry that are orthogonal with each other: plane AAA-AAA' horizontal on the figure, and plane BBB-BBB' vertical on the figure.

The arrangement of figure 6 has been observed to provide an ESR of about 0.8 ohms for a 2D capacitor having a capacitance of about 2nF.

In fact, in this embodiment, the capacitance is divided into the different portions of 2D capacitors. Also, the surface occupied by the 2D capacitor is maximized within the area surrounded by the metal contact of the 2D bottom metal contact: the 3D portions form low resistivity tracks that surround the multiple islands of 2D capacitor, which reduces the ESR and allows obtaining a large 2d capacitance value.

Various arrangement can be implemented, in accordance with the required 2D capacitor, the desired ESR, and the available surface area.

### Additional Variants

Although the present invention has been described above with reference to certain specific embodiments, it will be understood that the invention is not limited by the particularities of the specific embodiments. Numerous variations, modifications and developments may be made in the above-described embodiments within the scope of the appended claims.

## Claims

1. An electrical device comprising:
a substrate (300),
a conductive anodization barrier (303) above the substrate,
a metal region (304, REG) above the conductive anodization barrier,
an anodic porous oxide region (306) above the substrate, comprising straight pores extending from a top face of the anodic porous oxide region to the conductive oxidation battier, the anodic porous oxide region being adjacent to the metal region,
an insulating region (305, 307) above the metal region and the anodic porous oxide, having a first opening (OP1) delimiting a portion of the anodic porous oxide region and a second opening (OP2) delimiting a portion of the metal region,
a bottom capacitor electrode layer including a 3D portion (308A) extending inside the pores of the portion anodic porous oxide region and a 2D portion (308B) extending above the insulating region, the 2D portion and the 3D portion of the bottom capacitor electrode layer being in electrical contact,
a dielectric layer including a 2D portion (309B) above the 2D portion of the first capacitor electrode layer, and a 3D portion (309A) above the 3D portion of the bottom capacitor electrode layer and inside the pores of the portion of the anodic porous oxide region,
a top capacitor electrode layer including a 2D portion (310B) above the 2D portion of the dielectric layer, and a 3D portion (310A) above the 3D portion of the dielectric layer and inside the pores of the portion,
a 2D top metal contact (311B) above and in electrical contact with the 2D portion of the top capacitor electrode layer,
a 3D top metal contact (311A) above and in electrical contact with the 3D portion of the top capacitor electrode layer, and
a 2D bottom metal contact (313) in the second opening, above and in electrical contact with the 2D portion of the bottom capacitor electrode layer through the portion of the metal region and the 3D portion of the bottom capacitor electrode layer.

2. The device of claim 1, wherein the device comprises a passivation layer (312) having:
a first opening delimiting the 2D top metal contact by exposing the 2D top metal contact,
a second opening delimiting the 3D top metal contact by exposing the 3D top metal contact,
a third opening delimiting the 2D bottom metal contact by exposing the 2D bottom metal contact.

3. The device of claim 1 or 2, wherein the metal region including the portion of the metal region in electrical contact with the 2D bottom metal contact partially surrounds the 3D portion of the top capacitor electrode layer and the 2D portion of the top capacitor electrode.

4. The device of claim 3, wherein the metal region including the portion of the metal region in electrical contact with the 2D bottom metal contact completely surrounds the 3D portion of the top capacitor electrode layer and the 2D portion of the top capacitor electrode.

5. The device of claim 3 or 4, wherein the second opening delimiting a portion of the metal region partially surrounds the 3D portion of the top capacitor electrode layer and the 2D portion of the top capacitor electrode layer.

6. The device of claim 5, wherein the second opening delimiting a portion of the metal region completely surrounds the 3D portion of the top capacitor electrode layer and the 2D portion of the top capacitor electrode layer.

7. The device of any one of claims 1 to 6, wherein the 2D portion of the top capacitor electrode layer is surrounded by the 3D portion of the top capacitor electrode layer.

8. The device of claim 7, comprising multiple 2D portions of the top capacitor electrode layer forming islands surrounded by the 3D portion of the top capacitor electrode layer.

9. The device of any one of claims 1 to 6, wherein the 3D portion of the top capacitor electrode layer is surrounded by the 2D portion of the top capacitor electrode layer.

10. The device of claim 9, comprising multiple 3D portions of the top capacitor electrode layer forming islands surrounded by the 2D portion of the top capacitor electrode layer.

11. The device of claim 9 or 10, wherein the 2D portion of the top capacitor electrode layer and the 3D portion of the top capacitor electrode layer are arranged so that a unitary pattern of the 2D portion of the top capacitor electrode layer and the 3D portion of the top capacitor electrode layer is repeated in a paving of the unitary pattern.

12. The device of any one of claim 1 to 11, wherein the device presents a first plane of symmetry when observed from the top.

13. The device of claim 12, wherein the device presents a second plane of symmetry orthogonal with the first plane of symmetry when observed from the top.

14. A method of manufacturing an electrical device according to claims 1 to 13 comprising:
providing a substrate (300),
forming a conductive anodization barrier (303) above the substrate,
depositing a metal layer above the substrate,
anodizing a region of the metal layer to obtain:
an anodic porous oxide region (306) above the substrate, comprising straight pores extending from a top face of the anodic porous oxide region to the conductive anodization barrier,
a metal region (304, REG) above the substrate, the anodic porous oxide region being adjacent to the metal region,
forming an insulating region (305, 307) above the metal region and the anodic porous oxide, having a first opening (OP1) delimiting a portion of the anodic porous oxide region and a second opening (OP2) delimiting a portion of the metal region,
forming a bottom capacitor electrode layer including a 3D portion (308A) extending inside the pores of the portion anodic porous oxide region and a 2D portion (308B) extending above the insulating region, the 2D portion and the 3D portion of the bottom capacitor electrode layer being in electrical contact,
forming a dielectric layer including a 2D portion (309B) above the 2D portion of the first capacitor electrode layer, and a 3D portion (309A) above the 3D portion of the bottom capacitor electrode layer and inside the pores of the portion of the anodic porous oxide region,
forming a top capacitor electrode layer including a 2D portion (310B) above the 2D portion of the dielectric layer, and a 3D portion (310A) above the 3D portion of the dielectric layer and inside the pores of the portion,
forming a 2D top metal contact (311B) above and in electrical contact with the 2D portion of the top capacitor electrode layer,
forming a 3D top metal contact (311A) above and in electrical contact with the 3D portion of the top capacitor electrode layer, and
forming a 2D bottom metal contact (313) in the second opening pad above and in electrical contact with the 2D portion of the bottom capacitor electrode layer through the portion of the metal region and the 3D portion of the bottom capacitor electrode layer.

15. A method for characterizing an electrical device, comprising measuring a capacitance value or a breakdown voltage or a leakage current or an equivalent series resistance of a capacitor formed between the 2D top metal contact and the 2D bottom metal contact on an electrical device in accordance with any one of claims 1 to 13.

## Patentansprüche

1. Elektrische Vorrichtung, umfassend:
ein Substrat (300),
eine leitende Anodisierungsbarriere (303) über dem Substrat,
einen Metallbereich (304, REG) über der leitenden Anodisierungsbarriere,
einen anodischen porösen Oxidbereich (306) über dem Substrat, umfassend gerade Poren, die sich von einer oberen Fläche des anodischen porösen Oxidbereichs zu der leitenden Oxidationsschicht erstrecken, wobei der anodische poröse Oxidbereich angrenzend an den Metallbereich ist,
einen isolierenden Bereich (305, 307) über dem Metallbereich und dem anodischen porösen Oxid, der eine erste Öffnung (OP1), die einen Teil des anodischen porösen Oxidbereichs begrenzt, und eine zweite Öffnung (OP2), die einen Teil des Metallbereichs begrenzt, aufweist,
eine untere Kondensatorelektrodenschicht, die einen 3D-Abschnitt (308A), der sich innerhalb der Poren des anodischen porösen Oxidbereichs erstreckt, und einen 2D-Abschnitt (308B), der sich über dem isolierenden Bereich erstreckt, beinhaltet, wobei der 2D-Abschnitt und der 3D-Abschnitt der unteren Kondensatorelektrodenschicht in elektrischem Kontakt sind,
eine dielektrische Schicht, die einen 2D-Abschnitt (309B) über dem 2D-Abschnitt der ersten Kondensatorelektrodenschicht und einen 3D-Abschnitt (309A) über dem 2D-Abschnitt der unteren Kondensatorelektrodenschicht und innerhalb der Poren des Abschnitts des anodischen porösen Oxidbereichs beinhaltet,
eine obere Kondensatorelektrodenschicht, die einen 2D-Abschnitt (310B) über dem 2D-Abschnitt der dielektrischen Schicht und einen 3D-Abschnitt (310A) über dem 3D-Abschnitt der dielektrischen Schicht und innerhalb der Poren des Abschnitts beinhaltet,
einen oberen 2D-Metallkontakt (311B) über und in elektrischem Kontakt mit dem 2D-Abschnitt der oberen Kondensatorelektrodenschicht,
einen oberen 3D-Metallkontakt (311A) über und in elektrischem Kontakt mit dem 3D-Abschnitt der oberen Kondensatorelektrodenschicht, und
einen unteren 2D-Metallkontakt (313) in der zweiten Öffnung, über und in elektrischem Kontakt mit dem 2D-Abschnitt der unteren Kondensatorelektrodenschicht durch den Abschnitt des Metallbereichs und den 3D-Abschnitt der unteren Kondensatorelektrodenschicht.

2. Vorrichtung nach Anspruch 1, wobei die Vorrichtung eine Passivierungsschicht (312) umfasst, die Folgendes aufweist:
eine erste Öffnung, die den oberen 2D-Metallkontakt begrenzt, indem der obere 2D-Metallkontakt freigelegt wird,
eine zweite Öffnung, die den oberen 3D-Metallkontakt begrenzt, indem der obere 3D-Metallkontakt freigelegt wird,
eine dritte Öffnung, die den unteren 2D-Metallkontakt begrenzt, indem der untere 2D-Metallkontakt freigelegt wird,

3. Vorrichtung nach Anspruch 1 oder 2, wobei der Metallbereich einschließlich des Abschnitts des Metallbereichs, der in elektrischem Kontakt mit dem unteren 2D-Metallkontakt ist, den 3D-Abschnitt der oberen Kondensatorelektrodenschicht und den 2D-Abschnitt der oberen Kondensatorelektrode teilweise umgibt.

4. Vorrichtung nach Anspruch 3, wobei der Metallbereich einschließlich des Abschnitts des Metallbereichs, der in elektrischem Kontakt mit dem unteren 2D-Metallkontakt ist, den 3D-Abschnitt der oberen Kondensatorelektrodenschicht und den 2D-Abschnitt der oberen Kondensatorelektrode vollständig umgibt.

5. Vorrichtung nach Anspruch 3 oder 4, wobei die zweite Öffnung, die einen Abschnitt des Metallbereichs begrenzt, den 3D-Abschnitt der oberen Kondensatorelektrodenschicht und den 2D-Abschnitt der oberen Kondensatorelektrodenschicht teilweise umgibt.

6. Vorrichtung nach Anspruch 5, wobei die zweite Öffnung, die einen Abschnitt des Metallbereichs begrenzt, den 3D-Abschnitt der oberen Kondensatorelektrodenschicht und den 2D-Abschnitt der oberen Kondensatorelektrodenschicht vollständig umgibt.

7. Vorrichtung nach einem der Ansprüche 1 bis 6, wobei der 2D-Abschnitt der oberen Kondensatorelektrodenschicht von dem 3D-Abschnitt der oberen Kondensatorelektrodenschicht umgeben ist.

8. Vorrichtung nach Anspruch 7, umfassend mehrere 2D-Abschnitte der oberen Kondensatorelektrodenschicht, die Inseln bilden, die von dem 3D-Abschnitt der oberen Kondensatorelektrodenschicht umgeben sind.

9. Vorrichtung nach einem der Ansprüche 1 bis 6, wobei der 3D-Abschnitt der oberen Kondensatorelektrodenschicht von dem 2D-Abschnitt der oberen Kondensatorelektrodenschicht umgeben ist.

10. Vorrichtung nach Anspruch 9, umfassend mehrere 3D-Abschnitte der oberen Kondensatorelektrodenschicht, die Inseln bilden, die von dem 2D-Abschnitt der oberen Kondensatorelektrodenschicht umgeben sind.

11. Vorrichtung nach Anspruch 9 oder 10, wobei der 2D-Abschnitt der oberen Kondensatorelektrodenschicht und der 3D-Abschnitt der oberen Kondensatorelektrodenschicht angeordnet sind, sodass ein einzelnes Muster des 2D-Abschnitts der oberen Kondensatorelektrodenschicht und des 3D-Abschnitts der oberen Kondensatorelektrodenschicht in einem Mosaik des einzelnen Musters wiederholt wird.

12. Vorrichtung nach einem der Ansprüche 1 bis 11, wobei die Vorrichtung bei Betrachtung von oben eine erste Symmetrieebene aufweist.

13. Vorrichtung nach Anspruch 12, wobei die Vorrichtung bei Betrachtung von oben eine zweite Symmetrieebene aufweist, die orthogonal zu der ersten Symmetrieebene ist.

14. Verfahren zum Herstellung einer elektrischen Vorrichtung nach einem der Ansprüche 1 bis 13, umfassend:
Bereitstellen eines Substrats (300);
Bilden einer leitenden Anodisierungsbarriere (303) über dem Substrat,
Aufbringen einer Metallschicht über dem Substrat,
Anodisieren eines Bereichs der Metallschicht, um Folgendes zu erlangen:
einen anodischen porösen Oxidbereich (306) über dem Substrat, umfassend gerade Poren, die sich von einer oberen Fläche des anodischen porösen Oxidbereichs zu der leitenden Anodisierungsbarriere erstrecken,
einen Metallbereich (304, REG) über dem Substrat, wobei der anodische poröse Oxidbereich angrenzend an den Metallbereich ist,
Bilden eines isolierenden Bereichs (305, 307) über dem Metallbereich und dem anodischen porösen Oxid, der eine erste Öffnung (OP1), die einen Abschnitt des anodischen porösen Oxidbereichs begrenzt, und eine zweite Öffnung (OP2), die einen Teil des Metallbereichs begrenzt, aufweist,
Bilden einer unteren Kondensatorelektrodenschicht, die einen 3D-Abschnitt (308A), der sich innerhalb der Poren des anodischen porösen Oxidbereichs erstreckt, und einen 2D-Abschnitt (308B), der sich über dem isolierenden Bereich erstreckt, beinhaltet, wobei der 2D-Abschnitt und der 3D-Abschnitt der unteren Kondensatorelektrodenschicht in elektrischem Kontakt sind,
Bilden einer dielektrischen Schicht, die einen 2D-Abschnitt (309B) über dem 2D-Abschnitt der ersten Kondensatorelektrodenschicht und einen 3D-Abschnitt (309A) über dem 3D-Abschnitt der unteren Kondensatorelektrodenschicht und innerhalb der Poren des Abschnitts des anodischen porösen Oxidbereichs beinhaltet,
Bilden einer oberen Kondensatorelektrodenschicht, die einen 2D-Abschnitt (310B) über dem 2D-Abschnitt der dielektrischen Schicht und einen 3D-Abschnitt (310A) über dem 3D-Abschnitt der dielektrischen Schicht und innerhalb der Poren des Abschnitts beinhaltet,
Bilden eines oberen 2D-Metallkontakts (311B) über und in elektrischem Kontakt mit dem 2D-Abschnitt der oberen Kondensatorelektrodenschicht,
Bilden eines oberen 3D-Metallkontakts (311A) über und in elektrischem Kontakt mit dem 3D-Abschnitt der oberen Kondensatorelektrodenschicht, und
Bilden eines unteren 2D-Metallkontakts (313) in dem zweiten Öffnungspad, über und in elektrischem Kontakt mit dem 2D-Abschnitt der unteren Kondensatorelektrodenschicht durch den Abschnitt des Metallbereichs und den 3D-Abschnitt der unteren Kondensatorelektrodenschicht.

15. Verfahren zum Charakterisieren einer elektrischen Vorrichtung, umfassend ein Messen eines Kapazitätswerts oder einer Durchbruchspannung oder eines Leckstroms oder eines äquivalenten Serienwiderstands eines Kondensators, der zwischen dem oberen 2D-Metallkontakt und dem unteren 2D-Metallkontakt auf einer elektrischen Vorrichtung gemäß einem der Ansprüche 1 bis 13 gebildet ist.

## Revendications

1. Composant électrique comprenant :
un substrat (300),
une barrière d'anodisation conductrice (303) au-dessus du substrat,
une zone de métal (304, REG) au-dessus de la barrière d'anodisation conductrice,
une zone d'oxyde poreux anodique (306) au-dessus du substrat, comprenant des pores droits qui s'étendent depuis une face supérieure de la zone d'oxyde poreux anodique jusqu'à la barrière d'oxydation conductrice, la zone d'oxyde poreux anodique étant adjacente à la zone de métal,
une zone d'isolation (305, 307) au-dessus de la zone de métal et de l'oxyde poreux anodique, ayant une première ouverture (OP1) qui délimite une partie de la zone d'oxyde poreux anodique et une deuxième ouverture (OP2) qui délimite une partie de la zone de métal,
une couche d'électrode de condensateur inférieure comportant une partie en 3D (308A) qui s'étend à l'intérieur des pores de la partie de la zone d'oxyde poreux anodique et une partie en 2D (308B) qui s'étend au-dessus de la zone d'isolation, la partie en 2D et la partie en 3D de la couche d'électrode de condensateur inférieure étant en contact électrique,
une couche diélectrique comportant une partie en 2D (309B) au-dessus de la partie en 2D de la première couche d'électrode de condensateur, et une partie en 3D (309A) au-dessus de la partie en 3D de la couche d'électrode de condensateur inférieure et à l'intérieur des pores de la partie de la zone d'oxyde poreux anodique,
une couche d'électrode de condensateur supérieure comportant une partie en 2D (310B) au-dessus de la partie en 2D de la couche diélectrique, et une partie en 3D (310A) au-dessus de la partie en 3D de la couche diélectrique et à l'intérieur des pores de la partie,
un contact métallique supérieur en 2D (311B) au-dessus de et en contact électrique avec la partie en 2D de la couche d'électrode de condensateur supérieure,
un contact métallique supérieur en 3D (311A) au-dessus de et en contact électrique avec la partie en 3D de la couche d'électrode de condensateur supérieure, et
un contact métallique inférieur en 2D (313) dans la deuxième ouverture, au-dessus de et en contact électrique avec la partie en 2D de la couche d'électrode de condensateur inférieure à travers la partie de la zone de métal et la partie en 3D de la couche d'électrode de condensateur inférieure.

2. Composant selon la revendication 1, dans lequel le composant comprend une couche de passivation (312) ayant :
une première ouverture qui délimite le contact métallique supérieur en 2D en exposant le contact métallique supérieur en 2D,
une deuxième ouverture qui délimite le contact métallique supérieur en 3D en exposant le contact métallique supérieur en 3D,
une troisième ouverture qui délimite le contact métallique inférieur en 2D en exposant le contact métallique inférieur en 2D.

3. Composant selon la revendication 1 ou 2, dans lequel la zone de métal comportant la partie de la zone de métal en contact électrique avec le contact métallique inférieur en 2D entoure partiellement la partie en 3D de la couche d'électrode de condensateur supérieure et la partie en 2D de l'électrode de condensateur supérieure.

4. Composant selon la revendication 3, dans lequel la zone de métal comportant la partie de la zone de métal en contact électrique avec le contact métallique inférieur en 2D entoure complètement la partie en 3D de la couche d'électrode de condensateur supérieure et la partie en 2D de l'électrode de condensateur supérieure.

5. Composant selon la revendication 3 ou 4, dans lequel la deuxième ouverture qui délimite une partie de la zone de métal entoure partiellement la partie en 3D de la couche d'électrode de condensateur supérieure et la partie en 2D de la couche d'électrode de condensateur supérieure.

6. Composant selon la revendication 5, dans lequel la deuxième ouverture qui délimite une partie de la zone de métal entoure complètement la partie en 3D de la couche d'électrode de condensateur supérieure et la partie en 2D de la couche d'électrode de condensateur supérieure.

7. Composant selon l'une quelconque des revendications 1 à 6, dans lequel la partie en 2D de la couche d'électrode de condensateur supérieure est entourée par la partie en 3D de la couche d'électrode de condensateur supérieure.

8. Composant selon la revendication 7, comprenant plusieurs parties en 2D de la couche d'électrode de condensateur supérieure qui forment des îlots entourés par la partie en 3D de la couche d'électrode de condensateur supérieure.

9. Composant selon l'une quelconque des revendications 1 à 6, dans lequel la partie en 3D de la couche d'électrode de condensateur supérieure est entourée par la partie en 2D de la couche d'électrode de condensateur supérieure.

10. Composant selon la revendication 9, comprenant plusieurs parties en 3D de la couche d'électrode de condensateur supérieure qui forment des îlots entourés par la partie en 2D de la couche d'électrode de condensateur supérieure.

11. Composant selon la revendication 9 ou 10, dans lequel la partie en 2D de la couche d'électrode de condensateur supérieure et la partie en 3D de la couche d'électrode de condensateur supérieure sont prévues de sorte qu'un motif unitaire de la partie en 2D de la couche d'électrode de condensateur supérieure et de la partie en 3D de la couche d'électrode de condensateur supérieure soit répété sur un pavage du motif unitaire.

12. Composant selon l'une quelconque des revendications 1 à 11, dans lequel le composant présente un premier plan de symétrie lorsqu'il est observé depuis le dessus.

13. Composant selon la revendication 12, dans lequel le composant présente un deuxième plan de symétrie orthogonal par rapport au premier plan de symétrie lorsqu'il est observé depuis le dessus.

14. Procédé de fabrication d'un composant électrique selon les revendications 1 à 13 comprenant :
fournir un substrat (300),
la formation d'une barrière d'anodisation conductrice (303) au-dessus du substrat,
le dépôt d'une couche de métal au-dessus du substrat,
l'anodisation d'une zone de la couche de métal afin d'obtenir :
une zone d'oxyde poreux anodique (306) au-dessus du substrat, comprenant des pores droits qui s'étendent depuis une face supérieure de la zone d'oxyde poreux anodique jusqu'à la barrière d'anodisation conductrice,
une zone de métal (304, REG) au-dessus du substrat, la zone d'oxyde poreux anodique étant adjacente à la zone de métal,
la formation d'une zone d'isolation (305, 307) au-dessus de la zone de métal et de l'oxyde poreux anodique, ayant une première ouverture (OP1) qui délimite une partie de la zone d'oxyde poreux anodique et une deuxième ouverture (OP2) qui délimite une partie de la zone de métal,
la formation d'une couche d'électrode de condensateur inférieure comportant une partie en 3D (308A) qui s'étend à l'intérieur des pores de la partie de la zone d'oxyde poreux anodique et une partie en 2D (308B) qui s'étend au-dessus de la zone d'isolation, la partie en 2D et la partie en 3D de la couche d'électrode de condensateur inférieure étant en contact électrique,
la formation d'une couche diélectrique comportant une partie en 2D (309B) au-dessus de la partie en 2D de la première couche d'électrode de condensateur, et une partie en 3D (309A) au-dessus de la partie en 3D de la couche d'électrode de condensateur inférieure et à l'intérieur des pores de la partie de la zone d'oxyde poreux anodique,
la formation d'une couche d'électrode de condensateur supérieure comportant une partie en 2D (310B) au-dessus de la partie en 2D de la couche diélectrique, et une partie en 3D (310A) au-dessus de la partie en 3D de la couche diélectrique et à l'intérieur des pores de la partie,
la formation d'un contact métallique supérieur en 2D (311B) au-dessus de et en contact électrique avec la partie en 2D de la couche d'électrode de condensateur supérieure,
la formation d'un contact métallique supérieur en 3D (311A) au-dessus de et en contact électrique avec la partie en 3D de la couche d'électrode de condensateur supérieure, et
la formation d'un contact métallique inférieur en 2D (313) dans la deuxième ouverture, au-dessus de et en contact électrique avec la partie en 2D de la couche d'électrode de condensateur inférieure à travers la partie de la zone de métal et la partie en 3D de la couche d'électrode de condensateur inférieure.

15. Procédé destiné à caractériser un composant électrique, comprenant la mesure d'une valeur de capacitance ou d'une tension de rupture ou d'un courant de fuite ou d'une résistance série équivalente d'un condensateur formé entre le contact métallique supérieur en 2D et le contact métallique inférieur en 2D sur un composant électrique selon l'une quelconque des revendications 1 à 13.
